# EUROPEAN PATENT APPLICATION

(11) **EP 4 009 755 A1**
(43) Date of publication of application: **08.06.2022**
(21) Application number: 20864600.0
(22) Date of filing: 18.09.2020
(51) Int. Cl.: H05K 7/20

(54) **BACKPLANE ASSEMBLY AND SUBRACK**

(30) Priority: 20.09.2019 CN 201910894474
(71) Applicant: ZTE Corporation, Shenzhen, Guangdong 518057 (CN)
(72) Inventor: WU, Yu, Shenzhen, Guangdong 518057 (CN); REN, Chenghu, Shenzhen, Guangdong 518057 (CN); QIN, Zhenjun, Shenzhen, Guangdong 518057 (CN); ZHAO, Fei, Shenzhen, Guangdong 518057 (CN); YANG, Tao, Shenzhen, Guangdong 518057 (CN)
(74) Representative: Savi, Massimiliano
(86) International application number: PCT/CN2020/116078
(87) International publication number: WO 2021/052449

(57) **Abstract**

A backplane assembly and a subrack are disclosed. The subrack includes a subrack housing, a fan module arranged on the subrack housing, and a main backplane (7) and a fan backplane (8) which are fixed in the subrack housing. The main backplane (7) and the fan backplane (8) are separated from each other, and the fan backplane (8) is connected to the fan module fixed on the subrack housing for controlling the fan module.

## Description

### CROSS-REFERENCE TO RELATED APPLICATION

The present application is filed based on the Chinese Patent application No. 201910894474.8 filed on September 20, 2019, and claims priority of the Chinese Patent application, the entire contents of which are incorporated herein by reference.

### TECHNICAL FIELD

The present invention relates to the field of communication technologies, and in particular to a backplane assembly and a subrack.

### BACKGROUND

As the power consumption of communication devices increases, the requirement for the heat dissipation capacity of subracks is getting higher and higher. The heat dissipation capacity of a subrack is closely related to an air passage form of the entire system, areas of an air inlet and an air outlet, and the capacity and number of fans. Although changing any of the above factors can improve the heat dissipation capability of a device, in the actual design process, these factors are mutually restricted and influenced, and it is thus difficult to change any factor due to as the limitations of layout, space size and other conditions.

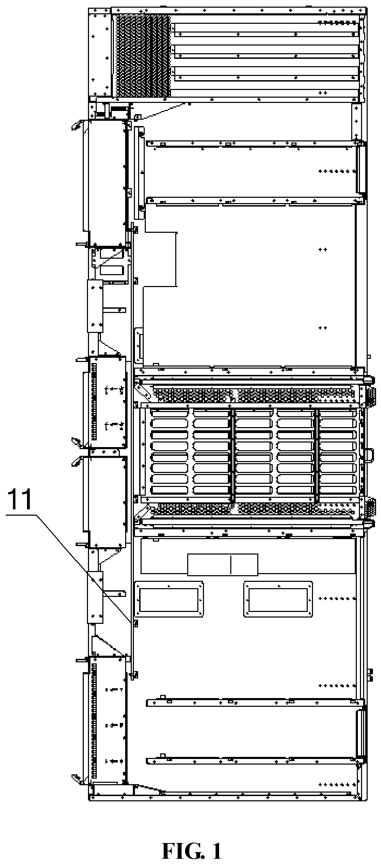

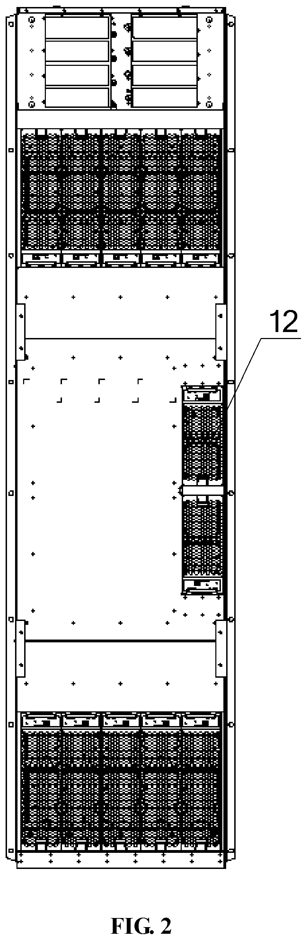

In some cases, a backplane is arranged inside a relevant subrack, and is integrated with circuits and devices for driving and controlling various modules, including a fan drive and control circuit and devices for driving and controlling a fan module arranged on the subrack for heat dissipation. Referring to FIG. 1 and FIG. 2, a subrack shown in the drawings is provided with a backplane 11, which is integrated with various circuits and devices for driving and controlling various modules in the subrack. While this structure has the advantage of good integration level, the integration of various circuits and devices onto one backplane is constrained by areas and positions of the circuits and devices, resulting in a limitation in positions and areas of the circuit and devices configured to control the fan module on the backplane, and as a result, the arrangement and number of fans on the subrack are limited, referring to a fan module 12 shown in FIG. 2 as an example, failing to optimize the heat dissipation effect of the subrack.

### SUMMARY

Embodiments of the present invention provide a backplane assembly and a subrack, aiming at solving one of the related technical problems at least to a certain degree, including the problem that the arrangement of one backplane in a subrack leads to a limitation in positions and areas of the circuits and device configured to control a fan module on the backplane, resulting in a limitation in the arrangement and number of fans on the subrack, failing to optimize the heat dissipation effect of the subrack.

In view of this, an embodiment of the present invention provides a backplane assembly, including: a main backplane 7 and a fan backplane 8 which are fixed in a subrack housing. The main backplane 7 and the fan backplane 8 are separated from each other, and the fan backplane 8 is connected to a fan module fixed on the subrack housing for controlling the fan module.

In view of this, an embodiment of the present invention further provides a subrack, including a subrack housing, a fan module arranged on the subrack housing, and a backplane assembly arranged in the subrack housing and connected to the fan module. The backplane assembly is the above-mentioned backplane assembly.

Other features and corresponding beneficial effects of the present invention will be set forth in the following parts of the description, and it should be understood that at least some of the beneficial effects will become apparent from the contents of the description of the present invention.

### BRIEF DESCRIPTION OF DRAWINGS

FIG. 1 is a schematic structural diagram of a backplane in a relevant subrack;
FIG. 2 is a schematic structural diagram of a fan module in the relevant subrack;
FIG. 3 is a front view of a subrack according to an embodiment of the present invention;
FIG. 4 is a rear view according to an embodiment of the present invention;
FIG. 5 is a schematic diagram of an internal structure in a left view of the subrack according to an embodiment of the present invention;
FIG. 6 is a schematic structural diagram of a main backplane according to an embodiment of the present invention;
FIG. 7 is a schematic diagram of a structure of connection between the main backplane and a fan backplane according to an embodiment of the present invention;
FIG. 8 is a schematic structural diagram of a fan backplane according to an embodiment of the present invention;
FIG. 9 is a schematic diagram of an airflow direction of the subrack according to an embodiment of the present invention;
FIG. 10 is a schematic structural diagram of mounting rails in a slot in the subrack according to an embodiment of the present invention;
FIG. 11 is a schematic structural diagram of the mounting of a service board according to an embodiment of the present invention;
FIG. 12 is a schematic structural diagram of a service board and a service board mounting rail according to an embodiment of the present invention;
FIG. 13 is a schematic structural diagram of the mounting of an air baffle according to an embodiment of the present invention;
FIG. 14 is a schematic structural diagram of the air baffle according to an embodiment of the present invention;
FIG. 15 is a schematic diagram of a mounted structure of the air baffle and the service board according to an embodiment of the present invention; and
FIG. 16 is a schematic structural diagram of the mounting of another service board according to an embodiment of the present invention.

### DETAILED DESCRIPTION

In order to make the objectives, technical schemes and advantages of the present invention clearer, the embodiments of the present invention will be further described in detail below through embodiments in conjunction with the accompanying drawings. It should be understood that the embodiments described herein are only used to explain the present invention rather than to limit the present invention.

In view of the problem in some cases that the arrangement of one backplane in a subrack and the integration of various circuits and devices for driving and controlling various modules in the subrack onto this backplane lead to a limitation in positions and areas of the circuit and devices configured to control a fan module on the backplane, resulting in a limitation in the arrangement and number of fans on the subrack, failing to optimize the heat dissipation effect of the subrack. The present embodiment provides a backplane assembly, which may be applied to, but not limited to, a subrack, as well as other devices that need to be provided with the backplane assembly in the present embodiment.

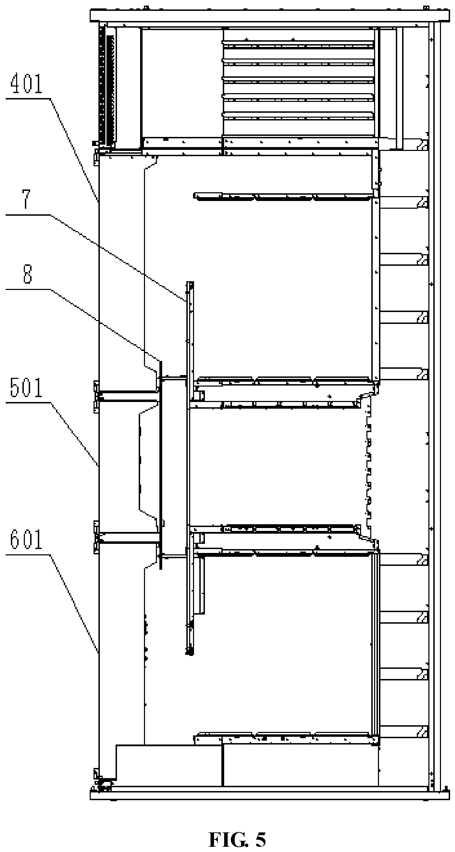

Referring to FIGs. 5 to 8, the backplane assembly includes a main backplane 7 and a fan backplane 8 which are fixed in a subrack housing. The main backplane 7 and the fan backplane 8 are separated from each other, and the fan backplane 8 is connected to a fan module fixed on the subrack housing for controlling a fan module. The main backplane 7 and the fan backplane 8 are separated from each other, so that the arrangement of positions and areas of circuits and devices configured to control the fan module on the fan backplane 8 is not limited by other circuits and devices on the main backplane 7, making the arrangement and number of fans on the subrack as reasonable as possible, thus improving the heat dissipation effect of the subrack.

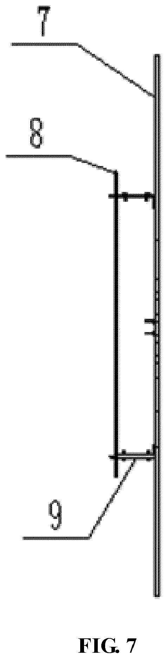

It should be understood that the main backplane 7 and the fan backplane 8 in the present embodiment may be flexibly shaped and structured according to specific requirements. In addition, in the present embodiment, the specific positions where the main backplane 7 and the fan backplane 8 are fixed in the subrack housing may also be flexibly set according to requirements. The fan backplane 8 and the main backplane 7 may be physically fixedly connected, or may physically have no fixed connection relationship according to requirements. For example, in an example, referring to FIG. 7, the backplane assembly of the subrack may further include a mounting bracket 9, through which the fan backplane 8 is fixed on the main backplane. It should be understood that the specific structure of the mounting bracket 9 in the present embodiment may also be set flexibly, as long as the fan backplane 8 can be fixed on the main backplane 7. In an example of the present embodiment, the back surfaces of the main backplane 7 and the fan backplane 8 are arranged opposite to each other, and the spacing between the main backplane 7 and the fan backplane 8 only needs to meet the space requirement of devices arranged on the main backplane 7 and the fan backplane 8. The fan backplane 8 is fixed on the main backplane 7, so that it is only necessary to fix the main backplane 7 or the fan backplane 8 to the subrack housing when the backplanes are fixed in the subrack housing. For example, referring to the example shown in FIG. 5, the main backplane 7 is fixed to the subrack housing, such that the main backplane 7 is also fixed on the subrack housing, increasing the efficiency of mounting. Certainly, in some examples, the main backplane 7 and the fan backplane 8 may also be fixed on the subrack housing at the same time.

In some examples of the present embodiment, when the main backplane 7 is fixed on the fan backplane 8, a shadow of at least part of the area of the main backplane 7 may project onto the fan backplane 8, that is, the main backplane 7 and the fan backplane 8 are at least partially superposed, for example referring to FIGs. 5 and 7.

In the present embodiment, in order to further improve the heat dissipation effect, a first air passage running through from the front surface to the back surface of the main backplane 7 is formed in the main backplane 7, a second air passage running through from the front surface to the back surface of the fan backplane 8 is formed in the fan backplane 8, and the first air passage and the second air passage are at least partially superposed and communicate with each other. Thus, cold air coming from the front surface of the subrack housing enters the first air passage from the front surface of the main backplane 7, and is dissipated out from a corresponding fan outlet through the second air passage in the fan backplane 8.

In addition, it should be understood that, in the present embodiment, the specific structures, sizes and shapes of the first air passage in the main backplane 7 and the second air passage in the fan backplane 8 may also be flexibly set, and the specific positions of the first air passage and the second air passage in the main backplane 7 and the fan backplane 8 may also be flexibly set according to specific requirements.

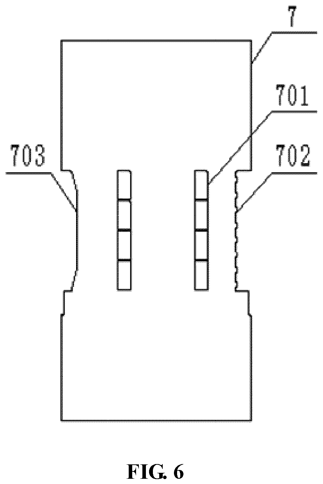

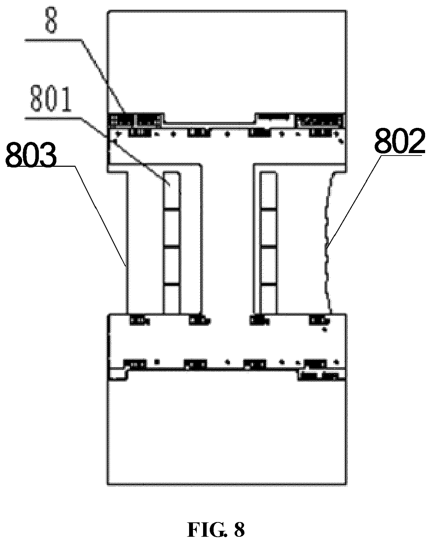

For example, in an example, referring to FIGs. 6 and 8, the first air passage in the main backplane 7 includes a first ventilation hole 701 formed in the main backplane 7, and the second air passage in the fan backplane 8 includes a second ventilation hole 801 formed in the fan backplane 8. After the fan backplane 8 is fixed on the main backplane 7, the first ventilation hole 701 and the second ventilation hole 801 are superposed, such that the first ventilation hole 701 and the second ventilation hole 801 communicate with each other. It should be understood that the specific hole shapes of the first ventilation hole 701 and the second ventilation hole 801 in the present embodiment may be the same or different. The specific shapes, sizes and layouts of the holes may be flexibly set.

For example, in another example, the first air passage in the main backplane 7 includes a first ventilation notch arranged in at least one side of the main backplane 7, and the second air passage in the fan backplane 8 includes a second ventilation notch arranged in at least one side of the fan backplane 8. After the fan backplane 8 is fixed on the main backplane 7, the first ventilation notch and the second ventilation notch are superposed, such that the first ventilation notch and the second ventilation notch communicate with each other.

For example, referring to FIGs. 6 and 8, the first ventilation notch in the main backplane 7 includes a first ventilation sub-notch 703 and a second ventilation sub-notch 702 which are arranged in the left side and right side of the main backplane 7 respectively; and the second ventilation notch in the fan backplane 8 includes a third ventilation sub-notch 803 and a fourth ventilation sub-notch 802 which are arranged in the left side and right side of the fan backplane 8 respectively. The first ventilation sub-notch 703 and the third ventilation sub-notch 803 are superposed and communicate with each other, and the second ventilation sub-notch 702 and the fourth ventilation sub-notch 802 are superposed and communicate with each other. The shapes and sizes of the first ventilation sub-notch 703 and the third ventilation sub-notch 803 may be the same or different. The shapes and sizes of the second ventilation sub-notch 702 and the fourth ventilation sub-notch 802 may also be set to be the same or different, and may be flexibly set according to specific requirements.

It should be understood that, in the present embodiment, the first ventilation hole 701, the first ventilation sub-notch 703 and the second ventilation sub-notch 702 may be arranged in the main backplane 7 at the same time, and the second ventilation hole 801, the third ventilation sub-notch 803 and the fourth ventilation sub-notch 802 may be arranged in the fan backplane 8 at the same time, so as to improve the heat dissipation effect of the first air passage and the second air passage. Certainly, through holes or notches for increasing the heat dissipation areas of the first air passage and the second air passage may also be additionally arranged on this basis.

The present embodiment further provides a subrack, including a subrack housing, a fan module arranged on the subrack housing, and a backplane assembly arranged in the subrack housing and connected to the fan module, and the backplane assembly is the above-mentioned backplane assembly.

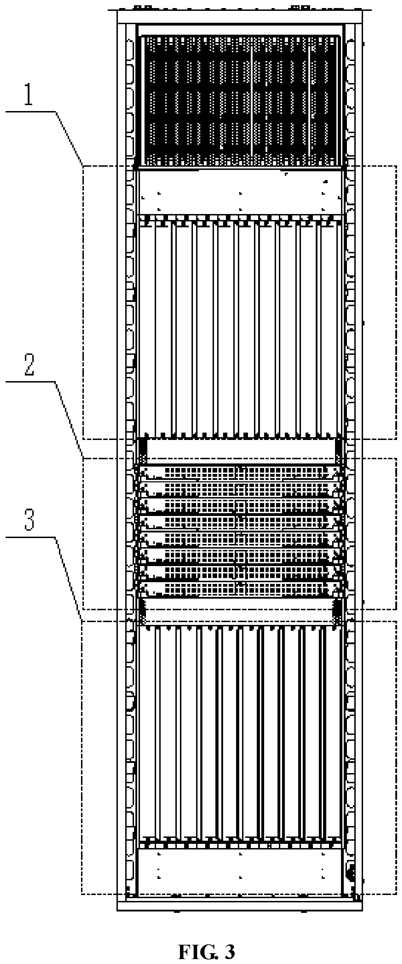

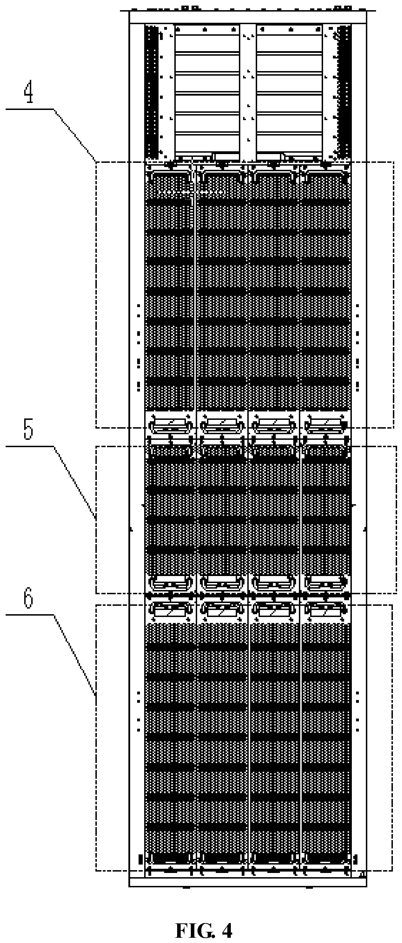

In an example, referring to FIGs. 3 to 5, the fan module arranged on the subrack includes a switch board fan module 501; the subrack housing includes a switch board area 2 close to the front surface of the subrack housing and configured for the arrangement of a switch board; and a switch fan area 5 close to the back surface of the subrack housing and corresponding to the switch board area 2 in position. The switch board fan module 501 is arranged in the switch fan area 5; and the main backplane 7 and the fan backplane 8 are arranged between the switch board area 2 and the switch fan area 5. Since the fan backplane 8 is separated from the main backplane 7, the arrangement of the positions and areas of circuits and devices for controlling the fan module on the fan backplane 8 are not limited by other circuits and devices on the main backplane 7, thus making the arrangement and number of fans on the subrack as reasonable as possible. Referring to the arrangement and number of the fans of the switch board fan module 501 in FIG. 4, compared with the fan module corresponding to the relevant switch board area shown in FIG. 2, the arrangement of the fans is more reasonable, the number of the fans is also greatly increased, and therefore the heat dissipation effect of the subrack is greatly improved.

In addition, in some cases, there is a sudden change in the path of the air passage in the relevant switch board area, such as a z-shaped air passage, a π-shaped air passage, or a u-shaped air passage. As a result, the path by which cold air enters and exits the subrack is not a straight line. Affected by the layout, the sudden change of direction increases the resistance of airflow, which greatly reduces the heat dissipation efficiency.

Referring to FIG. 5, the main backplane 7 and the fan backplane 8 arranged in the subrack housing are arranged in parallel, and the first air passage in the main backplane 7 and the second air passage the fan backplane 8 are arranged in a superposed configuration, such that the cold air entering from the front surface of the subrack housing enters a switch area for the switch board and is then directly discharged out from an air outlet of the switch board fan module 501 through the first air passage and the second air passage. The specific airflow path in the switch area for the switch board is a straight path, without a sudden change in the path of the air passage, so the efficiency of heat dissipation can be further increased.

In some examples of the present embodiment, the fan module arranged on the subrack housing may further include a service board fan module. The subrack housing further includes a service board area close to the front surface of the subrack housing, and a service fan area close to the back surface of the subrack housing and corresponding to the service board area in position. And the service board fan module is arranged in the service fan area.

For example, in an exemplary structure shown in FIGs. 3 to 5, the service board fan module includes an upper-layer service board fan module 401, the service board area includes an upper-layer service board area 1 located over the switch board area 2, the service fan area includes an upper-layer service fan area 4 located over the switch fan area 5, and the upper-layer service board fan module 401 is arranged in the upper-layer service fan area 4;
and/or
the service board fan module includes a lower-layer service board fan module 601, the service board area includes a lower-layer service board area 3 located under the switch board area 2, the service fan area includes a lower-layer service fan area 6 located under the switch fan area 5, and the lower-layer service board fan module 601 is arranged in the lower-layer service fan area 6.

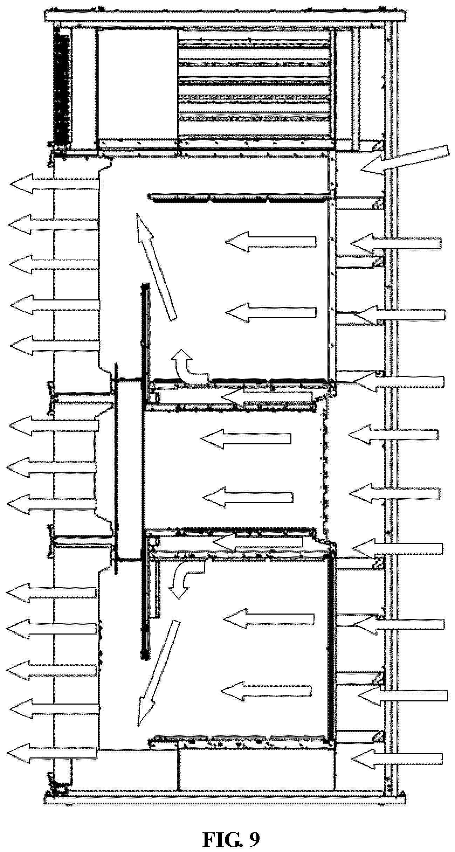

In some application scenarios of the present embodiment, the service board fan module includes the upper-layer service board fan module 401 and the lower-layer service board fan module 601. Referring to FIG. 9, the subrack housing allows air to enter from the front surface of the upper-layer service board, flow through the upper-layer service board area and exit from an air outlet of the upper-layer fan module 401; allows air to enter from the front surface of the switch board, flow through the switch board area and exit from an air outlet of the switch fan module 501; and allows air to enter from the front surface of the lower-layer service board, flow through the lower-layer service board area and exit from an air outlet of the lower-layer service board fan module 601. It should be understood that, in the present embodiment, the arrangement and data settings of the upper-layer service board fan module 401 and the lower-layer service board fan module 601 may be the same or different.

In some cases, each slot for fixing a service board in the subrack can only allow a service board of the same size to be inserted, which is not conducive to the extension and upgrade of the system. For example, once the size of a service board of a current product is set, if the service board needs more power consumption, a larger ventilation area and a larger heat sink size in the future, these demands cannot be achieved by changing or increasing the size of the service board, but can only be partially met by other means at a high cost.

With respect to this problem, in the present embodiment, at least one service board mounting slot is arranged in the service board area in the subrack housing, and each service board mounting slot includes at least two mounting rails arranged in parallel to each other, with at least one mounting rail serving as a service board mounting rail for the mounting of the service board. Since each service board mounting slot is provided with at least two parallel mounting rails, at least two single boards may be mounted in each service board mounting slot, and the mounted single boards may both be single service boards, or partially serve as a single service board and partially serve as an air baffle mounting rail for the mounting of the air baffle 104. The air baffle 104 is configured to block the remaining mounting gap of the service board mounting slot after the service board is mounted. Therefore, each mounting slot can be compatible with single service boards of various sizes.

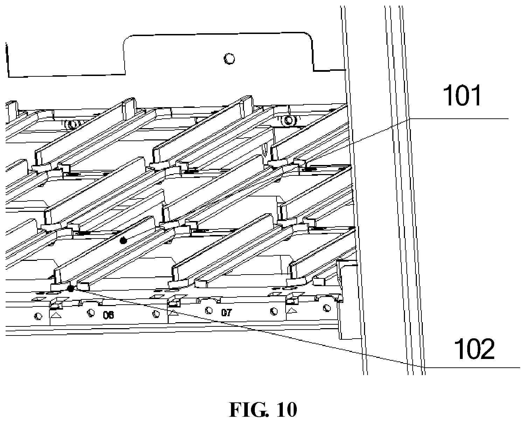

It should be understood that the specific number of the mounting rails arranged parallel to each other in each slot and the specific spacing between adjacent mounting rails may be flexibly set according to requirements. For example, in some examples, the mounting rails may be concave rails formed in the form of grooves, and in some examples, the mounting rails may be convex rails formed in the form of projections. In order to facilitate understanding, the present embodiment is hereinafter referred to with reference to FIGs. 10 to 16, and in the present embodiment, the specific structure of the mounting rails may also be flexibly set according to requirements. The examplary structure will be further explained.

Referring to FIG. 10, in the present embodiment, each service board mounting slot includes two mounting rails which are arranged in parallel to each other, with one mounting rail being a service board mounting rail for the mounting of the service board and the other mounting rail being an air baffle mounting rail for the mounting of the air baffle 104. In this example, the service board mounting rail is a concave rail 102, and the air baffle mounting rail is a convex rail 101.

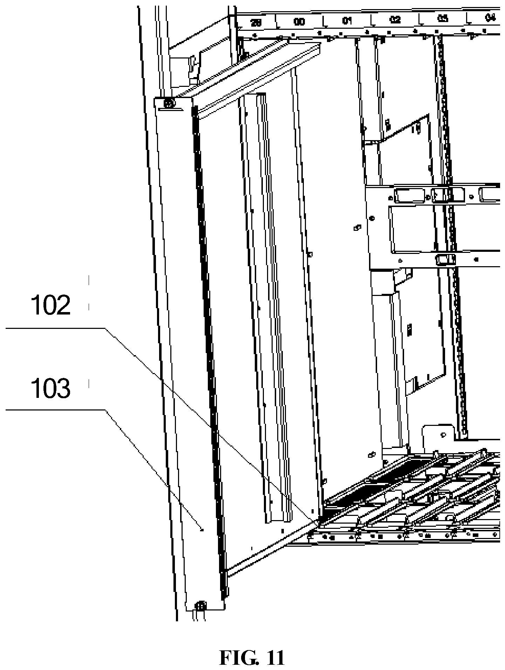

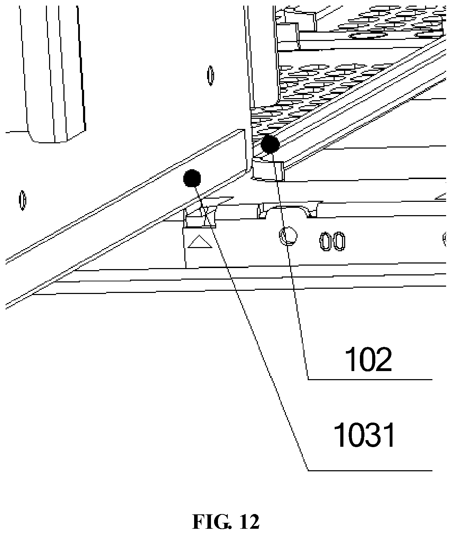

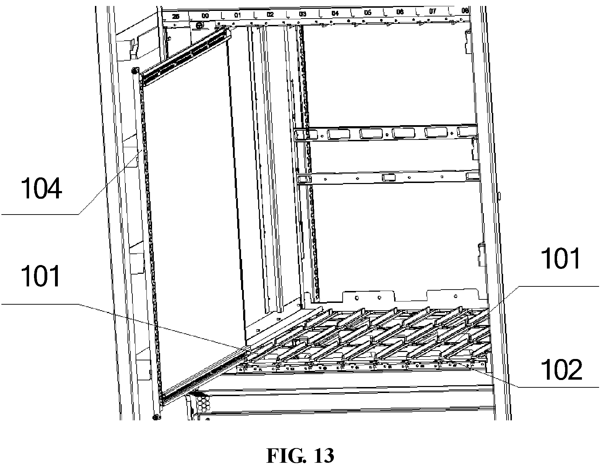

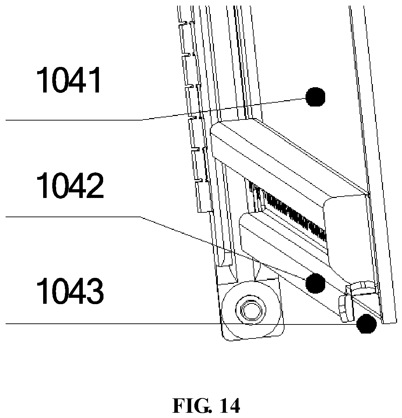

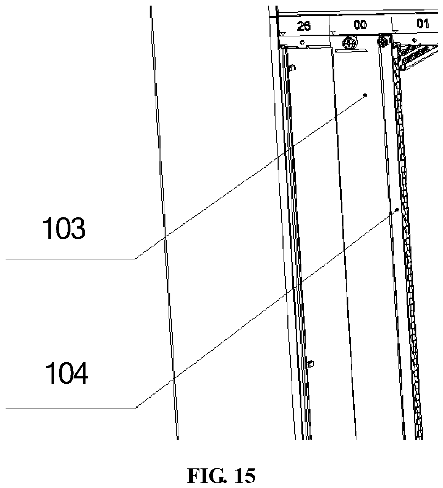

In an application scenario, referring to FIG. 11 and FIG. 12, the first service board 103 is inserted into a slot 00 in the subrack housing along the concave rail 102. A guide rail mating portion 1031 on the first service board 103 is mated with a groove of the concave rail 102 to ensure the smooth insertion and removal of the single board. In this application scenario, the first service board 103 is a relatively small single board, so the air baffle also needs to be mounted in the slot 00. Referring to FIG. 13, the air baffle 104 is inserted into the system slot along the convex rail 101. Referring to FIG. 14, a bottom surface 1041 of the air baffle 104 and an assembly 1042 with a stepped cross section form a slide rail groove 1043, and the slide rail groove 1043 is mated with the convex rail 101 to ensure the smooth insertion and removal of the air baffle. FIG. 15 shows a schematic structural diagram after the first service board 13 and the air baffle 104 are mounted in the slot. The arrangement of the air baffle 104 can effectively avoid air passage bypasses.

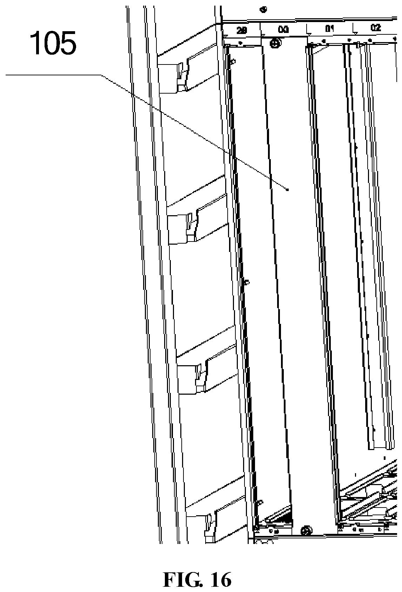

In other application scenarios of the present embodiment, a second service board larger than the first service board 13 may also be arranged in the subrack housing. Referring to FIG. 16, the second service board 105 larger than the first service board occupies the slot 00 shown in FIG. 16 after being inserted into the system. The width of the second service board 105 is greater than that of the first service board 103, such that more ventilation holes may be designed in the front surface of the second service board according to specific requirements to help the single board to dissipate heat.

It should be understood that the subrack in the present embodiment may support full configuration of the first service boards 103, full configuration of the second service boards 105 or mixed configuration of the first service boards 103 and the second service boards 105. The air baffle 104 is required when the first service board 103 and the second service board 105 are inserted into the system along the concave rail 102, and the air baffle 104 is inserted into the system along the convex rail 101. This mounting method breaks through the conventional design that a single slot is only adapted to single boards of the same size, realizes a design compatible with single boards of different sizes, extends the size range of single boards, increases the air intake area of the front surface of the single board, also enlarges the internal space of the single board, and allows a heat sink to be designed higher. The heat dissipation capacity of the single slot for the service board is enhanced.

The embodiments of the present invention provide a backplane assembly and a subrack. The subrack includes a subrack housing, a fan module arranged on the subrack housing, and a main backplane 7 and a fan backplane 8 which are fixed in the subrack housing. The main backplane 7 and the fan backplane 8 are separated from each other, and the fan backplane 8 is connected to the fan module fixed on the subrack housing for controlling the fan module. In the present embodiments, since the main backplane 7 and the fan backplane 8 are separated from each other, the arrangement of the positions and areas of circuits and devices for controlling the fan module on the fan backplane 8 is not limited by other circuits and devices on the main backplane 7, making the arrangement and number of the fans on the subrack as reasonable as possible, thus improving the heat dissipation effect of the subrack.

Those having ordinary skills in the art should understand that all or some of the steps, functional modules/units in the system, and devices in the methods disclosed above can be implemented as software (which can be implemented by computer program codes executable by a computing device), firmware, hardware and their appropriate combination. In the hardware implementation, the division between functional modules/units mentioned in the above description does not necessarily correspond to the division of physical components. For example, one physical component may have a plurality of functions, or one function or step may be executed by several physical components in cooperation. Some physical components or all physical components can be implemented as software executed by a processor, such as a central processing unit, a digital signal processor, or a microprocessor, or as hardware, or as an integrated circuit, such as an application specific integrated circuit.

In addition, as is well known to those having ordinary skills in the art, communication media usually contain computer-readable instructions, data structures, computer program modules, or other data in a modulated data signal such as a carrier wave or other transmission mechanism, and may include any information delivery medium. Therefore, the present invention is not limited to any specific hardware and software combination.

The above content is a further detailed description of the embodiments of the present invention in conjunction with specific implementations, and it cannot be considered that the specific implementations of the present invention are limited to these descriptions. For those having ordinary skills in the technical field to which the present invention belongs, several simple deductions or substitutions can be made without departing from the concept of the present invention, which should be regarded as falling within the protection scope of the present invention.

## Claims

1. A backplane assembly, comprising: a main backplane (7) and a fan backplane (8) which are fixed in a subrack housing, wherein the main backplane (7) and the fan backplane (8) are separated from each other, and the fan backplane (8) is connected to a fan module fixed on the subrack housing for controlling the fan module.

2. The backplane assembly of claim 1, further comprising a mounting bracket (9) for fixing the fan backplane (8) on the main backplane (7).

3. The backplane assembly of claim 1 or 2, wherein a first air passage running through from a front surface to a back surface of the main backplane (7) is formed in the main backplane (7), a second air passage running through from a front surface to a back surface of the fan backplane (8) is formed in the fan backplane (8), and the first air passage and the second air passage are at least partially superposed and communicate with each other.

4. The backplane assembly of claim 3, wherein the first air passage comprises a first ventilation hole (701) arranged in the main backplane (7), and the second air passage comprises a second ventilation hole (801) arranged in the fan backplane (8).

5. The backplane assembly of claim 3, wherein the first air passage comprises a first ventilation notch arranged in at least one side of the main backplane (7), and the second air passage comprises a second ventilation notch arranged in at least one side of the fan backplane (8).

6. The backplane assembly of claim 5, wherein the first ventilation notch comprises a first ventilation sub-notch (703) and a second ventilation sub-notch (702) which are arranged in a left side and a right side of the main backplane (7) respectively; and
the second ventilation notch comprises a third ventilation sub-notch (803) and a fourth ventilation sub-notch (802) which are arranged in a left side and a right side of the fan backplane (8) respectively.

7. A subrack, comprising a subrack housing, a fan module arranged on the subrack housing, and a backplane assembly arranged in the subrack housing and connected to the fan module, wherein the backplane assembly is the backplane assembly of any one of claims 1 to 6.

8. The subrack of claim 7, wherein the fan module comprises a switch board fan module (501); the subrack housing comprises a switch board area (2) close to a front surface of the subrack housing and configured for the arrangement of a switch board and a switch fan area (5) close to a back surface of the subrack housing and corresponding to the switch board area (2) in position; the switch board fan module (501) is arranged in the switch fan area (5); and the main backplane (7) and the fan backplane (8) are arranged between the switch board area (2) and the switch fan area (5).

9. The subrack of claim 7 or 8, wherein the fan module further comprises a service board fan module; the subrack housing further comprises a service board area close to the front surface of the subrack housing and a service fan area close to the back surface of the subrack housing and corresponding to the service board area in position; and the service board fan module is arranged in the service fan area.

10. The subrack of claim 9, wherein the service board fan module comprises an upper-layer service board fan module (401), the service board area comprises an upper-layer service board area (1) located over the switch board area (2), the service fan area comprises an upper-layer service fan area (4) located over the switch fan area (5), and the upper-layer service board fan module (401) is arranged in the upper-layer service fan area (4); and/or
the service board fan module comprises a lower-layer service board fan module (601), the service board area comprises a lower-layer service board area (3) located under the switch board area (2), the service fan area comprises a lower-layer service fan area (6) located under the switch fan area (5), and the lower-layer service board fan module (601) is arranged in the lower-layer service fan area (6).

11. The subrack of claim 9, wherein at least one service board mounting slot is arranged in the service board area in the subrack housing, and each service board mounting slot comprises at least two mounting rails arranged in parallel to each other, with at least one mounting rail serving as a service board mounting rail for the mounting of the service board.

12. The subrack of claim 11, wherein at least one of the at least two mounting rails arranged in parallel to each other serves as an air baffle mounting rail for the mounting of an air baffle (104), and the air baffle (104) is configured to block the remaining mounting gap of the service board mounting slot after the service board is mounted.
